Europäisches Patentamt

**European Patent Office**

**Office européen des brevets**

(11) Numéro de publication: **0 322 967 B1**

(12) **FASCICULE DE BREVET EUROPEEN**

(45) Date de publication de fascicule du brevet: **15.07.92**

(51) Int. Cl.⁵: **C03C 23/00**, C03C 17/06, H01L 25/16

(21) Numéro de dépôt: **88202952.3**

(22) Date de dépôt: **19.12.88**

(54) **Procédé de métallisation d'un substrat en silice, quartz, verre, ou en saphir et substrat obtenu par ce procédé.**

(30) Priorité: **23.12.87 FR 8718039**

(43) Date de publication de la demande:
**05.07.89 Bulletin 89/27**

(45) Mention de la délivrance du brevet:
**15.07.92 Bulletin 92/29**

(84) Etats contractants désignés:
**DE FR GB IT NL**

(56) Documents cités:
**FR-A- 2 212 302**

**CHEMICAL ABSTRACTS, vol. 106, no. 20, mai 1987, page 321, résumé no. 161376z, Columbus, Ohio, US; & JP-A-62 12 184 (TANAKA NOBLE METAL INDUSTRIAL CO., LTD) 21-01-1987**

**AMERICAN CERAMIC SOCIETY BULLETIN, vol. 55, no. 5, mai 1976, pages 530-532, Columbus, Ohio, US; D.E. CARLSON et al.: "Metallization of glass using ion injection"**

(73) Titulaire: **TRT TELECOMMUNICATIONS RADIOELECTRIOUES ET TELEPHONIOUES 88 rue Brillat Savarin F-75013 Paris(FR)**

(84) Etats contractants désignés:
**FR**

(73) Titulaire: **N.V. Philips' Gloeilampenfabrieken Groenewoudseweg 1 NL-5621 BA Eindhoven(NL)**

(84) Etats contractants désignés:
**DE GB IT NL**

(72) Inventeur: **Bourgeois-Moine, Jean Société Civile S.P.I.D. 209 Rue de l'Université F-75007 Paris(FR)**

(74) Mandataire: **Pyronnet, Jacques et al Société Civile S.P.I.D. 156, Boulevard Haussmann F-75008 Paris(FR)**

Rank Xerox (UK) Business Services

EP 0 322 967 B1

## Description

L'invention concerne un procédé permettant de faire adhérer du métal sur une surface de substrat en silice, quartz, verre, ou en saphir, selon lequel la surface à métalliser est d'abord rendue rugueuse par abrasion mécanique en vue d'obtenir une rugosité superficielle comprise entre 0,2 $\mu$m et 0,7 $\mu$m puis soumise à un traitement chimique de décapage par immersion pendant une durée efficace dans une solution aqueuse d'acide fluorhydrique.

L'invention concerne aussi les substrats métallisés obtenus par ce procédé.

Un domaine spécifique d'utilisation de l'invention est celui des circuits hybrides couches minces et des circuits hyperfréquences. Pour ces types de circuits, on utilise couramment comme supports des substrats d'alumine ou des substrats de silice, sous forme cristallisée ou amorphe. L'alumine cristalline, la plus utilisée, convient bien pour des fréquences de fonctionnement ne dépassant pas 15 GHz environ. Au-delà de cette fréquence, à cause d'une permittivité élevée, la largeur des pistes métalliques du circuit sur alumine devient faible, de l'ordre de 0,5 mm ce qui provoque des risques d'arrachement de ces pistes à l'endroit des connexions, et, pour la même raison, le substrat d'alumine devient très mince, de l'ordre de 0,25 mm, ce qui le rend fragile et difficile à usiner étant donnée la grande dureté de l'alumine. Par contre, un avantage de l'alumine en tant que support de circuit hyperfréquences, est que l'on sait le métalliser correctement par des procédés classiques : par exemple, par le procédé de pulvérisation cathodique, précédé des étapes de nettoyage, grillage et dégazage, il est possible d'obtenir des forces de pelage des pistes métalliques $F_p$ supérieures à 200 cN/mm, ce qui est suffisant pour l'application envisagée, l'inconvénient de la fragilité du matériau pour de faibles épaisseurs aux fréquences élevées étant prépondérant par rapport à l'inconvénient de l'arrachement des pistes. On notera que, en l'occurrence, l'obtention de forces de pelage élevées, quel que soit le procédé de métallisation utilisé tient surtout à une affinité chimique assez grande entre l'alumine et certains métaux utilisés comme sous couche de métallisation. A côté des substrats d'alumine, les substrats de silice, de quartz, de verre dur, ainsi que les substrats de saphir, conviennent pour des applications en hyperfréquence. Les substrats de silice conviennent particulièrement pour les fréquences de fonctionnement supérieures à 15 GHz. Les substrats à base de silice sont plus faciles à usiner que les substrats d'alumine, ont des pertes diélectriques moindres, et, pour la même fréquence de fonctionnement du circuit à réaliser, à cause de la faible constante diélectrique, $\epsilon r$, égale environ à 3,8 pour la silice contre 9,9 pour l'alumine sont moins fragiles parce que plus épais et ont des pistes métalliques plus larges. Le principal problème technique qui se pose dans ce cas est la faible adhérence des couches métalliques sur un substrat à base de silice, qui résulte de la faible affinité chimique, plus précisément de l'hydrophobie, entre silice et métal. Les procédés classiques connus tels que l'évaporation sous vide, la pulvérisation cathodique, le dépôt par voie gazeuse, le dépôt chimique, lorsqu'ils sont pratiqués directement sur un substrat qui n'est pas soumis à des traitements préalables particuliers, procurent des forces de pelage de l'ordre de 20 cN/mm, ce qui est généralement insuffisant pour la principale application envisagée indiquée ci-dessus. En effet, les contraintes que peuvent subir les pistes métalliques des circuits hybrides couches minces sont comparables à celles de circuits imprimés qui requièrent des forces de pelage égales ou supérieures à 80 cN/mm.

On connaît, par exemple du certificat d'utilité français 2 212 302 au nom de la société N.V. PHILIPS, un procédé de métallisation par dépôt chimique qui permet d'obtenir des forces de pelage allant jusqu'à 55 cN/mm. Selon ce procédé, le dépôt chimique proprement dit est précédé par deux étapes de traitement de la surface du substrat de verre dur : la première étape consiste à rendre rugueuse, par abrasion mécanique, la surface du verre jusqu'à lui conférer une rugosité Ra comprise entre 0,2 et 2,5 $\mu$m. La deuxième étape consiste ensuite à traiter la surface avec une solution aqueuse d'acide fluorhydrique conncentré pendant une à plusieurs dizaines de secondes. Les autres étapes concernent le dépôt chimique qui se décompose en l'application d'une couche de germes puis le renforcement avec du métal à l'aide d'une solution de métallisation. Ce procédé a pour lui l'avantage de la simplicité de mise en oeuvre et permet d'obtenir des résultats d'adhérence deux à trois fois meilleurs que ceux des procédés classiques sans traitement préalable de la surface à métalliser. Cependant, les forces d'adhérence des métallisations se révèlent encore insuffisantes pour les substrats à base de silice et la présente invention vise à améliorer encore cette adhérence.

Le principal but de l'invention est de faire adhérer du métal sur une surface de substrat en silice, quartz, verre ou en saphir, de façon à obtenir des forces de pelage supérieures à 80 cN/mm.

Un autre but de l'invention est de pouvoir disposer d'une gamme de sous couches métalliques plus complète que dans les procédés classiques.

Encore un autre but est d'obtenir une meilleure homogénéité de dépôt de sous couche métallique permettant une épaisseur de sous couche faible, de l'ordre de 20 à 30 nm, ce qui facilite l'enlèvement partiel de la sous couche par gravure lors de la réalisation de configurations métalliques éventuelles sur le substrat.

Ces buts sont atteints et les inconvénients de l'art antérieur sont atténués grâce au fait que le procédé de métallisation indiqué au premier paragraphe est remarquable en ce qu'il comporte en outre les étapes ultérieures suivantes :

- le décapage ionique (en milieu neutre) de la surface jusqu'à une profondeur inférieure à 50 nm,
- l'application sur la surface d'une première couche métallique d'adhérence par pulvérisation cathodique.

Le découpage ionique de la surface suivi de l'application sur la surface de couches métalliques d'adhérance par pulvérisation cathodique est connu en soi (JP-A-62 12 184).

Etant donnée la très faible affinité chimique entre les métaux et la silice, ou le saphir, l'idée de départ de l'invention est d'obtenir, avant l'étape de métallisation par pulvérisation cathodique, un état de surface du substrat en silice le plus apte possible à l'accrochage mécanique du métal sur le substrat, cet état de surface n'étant qu'en partie caractérisé par la rugosité finale Ra obtenue après gravure ionique réactive : c'est surtout la nature et l'aspect même du relief microscopique du substrat obtenu à ce stade du procédé qui sont alors en jeu, plutôt que la profondeur moyenne de ce relief.

Un mode de réalisation préféré de l'invention est remarquable en ce que le décapage ionique (en milieu neutre) de la surface est effectué par un plasma d'argon avec une puissance par unité de surface comprise entre 50 w/cm$^2$ et 71 w/cm$^2$ pendant une durée comprise entre 160 s et 200 s.

Un autre mode de réalisation préféré est remarquable en ce qu'il comporte en outre l'étape ultérieure consistant en l'application sur la surface métallisée d'une deuxième couche métallique conductrice, par pulvérisation cathodique, dont l'épaisseur est inférieure à 1 $\mu$m.

La première couche métallique ou sous couche, dite encore couche d'adhérence, est constituée d'un métal choisi surtout pour sa compatibilité chimique avec le substrat, tel Cr, NiCr, Ti, W ou autres. De plus, l'utilisation de NiCr permet la réalisation de résistances intégrées. La deuxième couche métallique, d'une épaisseur dix fois plus grande que celle de la sous couche ne pose pas de problème d'adhérence avec la sous couche ; elle est choisie pour ses propriétés de bon conducteur électrique ; il s'agit généralement de : Au, Ag ou Cu. Des procédés de photolithographie et de gravure chimique ou de gravure sèche sélective permettent de créer, sur des substrats métallisés sur toute une face ou sur les deux faces, au moins en ce qui concerne la sous couche métallique, des configurations métalliques résistantes ou conductrices. Selon les fréquences de fonctionnement prévues pour les circuits, l'épaisseur des conducteurs peut être plus ou moins grande, inférieure au micron aux très hautes fréquences et de l'ordre de plusieurs microns à des fréquences plus basses.

Une variante du procédé selon l'invention permettant d'obtenir des couches métalliques de plusieurs microns d'épaisseur est remarquable en ce qu'il comporte en outre l'étape ultérieure consistant en l'application sur la surface métallisée d'une troisième couche métallique conductrice de renforcement par dépôt électrolytique.

De préférence le dépôt électrolytique de la troisième couche métallique est effectué avec le même métal que celui de la deuxième couche et ce dépôt est effectué sur des configurations métalliques adhérant à la surface du substrat.

La description qui suit en regard des dessins annexés, le tout donné à titre d'exemple fera bien comprendre comment l'invention peut être réalisée.

Les figures 1a et 1b représentent respectivement, vu en plan et en coupe latérale, l'aspect connu d'une surface de substrat en silice après abrasion mécanique.

Les figures 2a et 2b représentent respectivement, vu en plan et en coupe latérale, l'aspect connu de la surface de la figure 1a et 1b après traitement par de l'acide fluorhydrique.

La figure 3 représente vu en plan l'aspect de la surface de la figure 2a après l'étape de gravure ionique réactive selon l'invention.

La figure 4 montre schématiquement le dispositif de décapage ionique (en milieu neutre) et de pulvérisation cathodique utilisé pour la mise en oeuvre de l'invention.

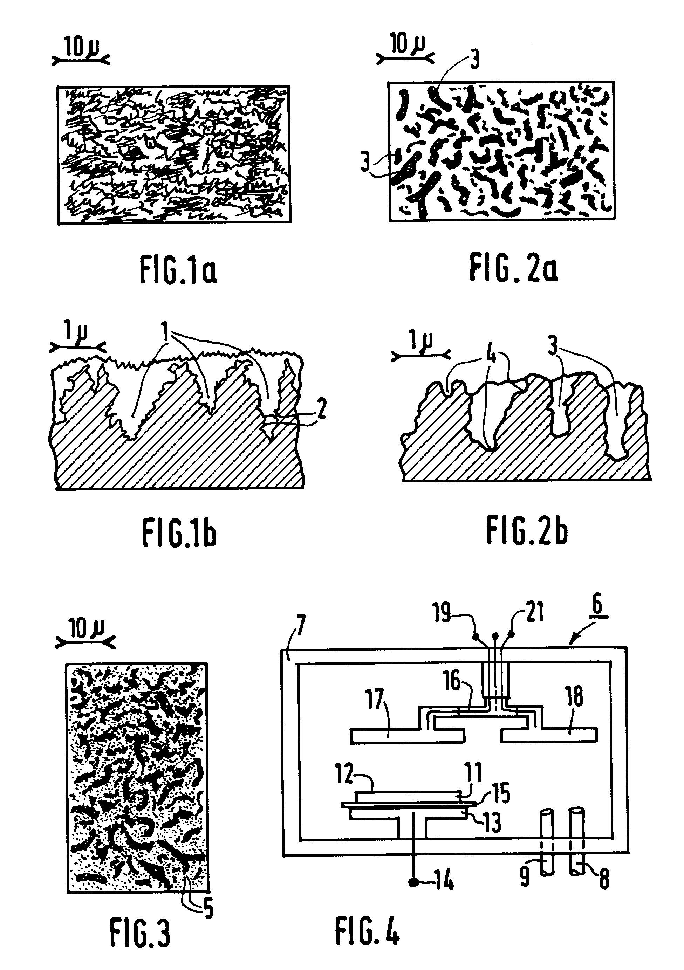

Lorsqu'on souhaite réaliser des couches métalliques sur la surface d'un substrat en verre ou en verre de quartz par dépôt chimique sans courant, il est connu, avant d'effectuer les étapes finales purement chimiques qui consistent à plonger le substrat successivement dans différentes solutions à base de sels métalliques, d'effectuer deux étapes préalables qui visent à traiter la surface du substrat pour lui conférer une rugosité apte à favoriser l'adhérence du métal déposé ultérieurement. Ces deux étapes connues sont utilisées pour la mise en oeuvre de la présente invention, pour le dépôt de couche(s) métallique(s) sur de la silice, du quartz, du verre ou du saphir et décrites ci-dessous en référence aux figures 1a, 1b, 2a et 2b.

Après usinage, la surface d'un substrat en silice destiné à des circuits hybrides couches minces ou à des circuits hyperfréquences présente une rugosité Ra de l'ordre de 0,3 $\mu$. Quel que soit le procédé utilisé ultérieurement pour la métallisation, il est souhaitable que la rugosité de surface du substrat ne soit pas trop élevée et de préférence inférieure à 1 $\mu$ pour éviter de trop grandes pertes par courant de Foucault à haute fréquence. La première étape du procédé selon l'invention consiste à effectuer une abrasion mécanique de la surface en vue d'obtenir une rugosité superficielle Ra telle que :

0,2 μ < Ra<0,7.

La surface est abrasée par exemple à l'aide de papier émeri fin ou de grains de carborundum. Les grains de carborundum ont un diamètre compris entre 20 et 40 μm et le traitement dure de 60 à 180 s. On peut aussi traiter la surface par sablage. Le résultat obtenu est représenté aux figures 1a et 1b où les échelles respectives de 10 μm et de 1 μm sont indiquées. La surface obtenue a un aspect chaotique. Elle est constituée, à l'échelle du micron, par des vallées 1 en forme de V qui s'entrecroisent. A l'échelle de 100 nm on observe un relief plus fin, constitué par des rugosités environ dix fois plus fines référencées 2. La surface est ensuite nettoyée de la façon habituelle. Lors d'un premier nettoyage, dit nettoyage primaire, on utilise des détergents et des solvants de classe technique et la surface est rincée dans de l'eau désionisée courante pendant 1 mn. Lors d'un nettoyage secondaire, on utilise des détergents et des solvants de haute pureté ; la surface est à nouveau rincée dans de l'eau désionisée courante.

Pour la deuxième étape principale connue du procédé, le susbstrat nettoyé et rincé est immergé dans une solution aqueuse d'acide fluorhydrique concentré à température ambiante. De préférence, la concentration de HF est forte, de l'ordre de 40 % en poids, pour une durée d'immersion comprise entre 37 et 43 s, ce qui constitue une durée efficace. Il est à la portée de l'homme de l'art de pratiquer des concentrations d'acide moins fortes, associées à des durées d'immersion plus élevées. Le résultat obtenu est représenté aux figures 2a et 2b où les échelles respectives de 10 μm et 1 μm sont encore indiquées. La rugosité Ra a été augmentée de 20 % environ de façon telle que :

0,25<Ra<0,85

mais cette faible augmentation de la rugosité est pratiquement sans influence sur l'adhérence qu'on recherche pour la métallisation ultérieure. Par contre on observe que l'aspect de la surface est complètement différent de celui des figures 1a et 1b. Le relief principal est constitué par des vallées vermiformes 3. Ces vallées 3 sont fermées et présentent une section en U, ce qui est beaucoup plus favorable à conférer de l'adhérence que les vallées du type 1. Par contre les rugosités fines 2 ont été pratiquement effacées sous l'effet de l'acide et, à l'échelle de 100 nm la surface obtenue est pratiquement lisse, mise à part la formation de quelques criques 4 de 200 à 300 nm de diamètre. On notera que l'aspect des surfaces représenté schématiquement aux figures 1a et 2a peut être caractérisé au microscope à balayage électronique. A ce stade connu du procédé le substrat est séché dans une étuve ventilée à 120°C pendant 15 mn ; il peut alors être stocké pendant plusieurs mois dans une enceinte remplie d'azote sec de qualité U.

Les étapes capitales du procédé selon l'invention consistent ensuite à faire subir à la surface de substrat telle qu'obtenue par les étapes décrites ci-dessus un procédé de pulvérisation cathodique, en salle blanche, qui se décompose lui-même en plusieurs phases.

Le substrat est d'abord soumis à un étuvage sous vide primaire à une température comprise entre 250 et 350°C visant à déshydrater la surface à métalliser. La pression descend de 100 mTorr à 10 mTorr en 90 s puis est maintenue à cette dernière valeur de 10 mTorr pendant au moins 90 s.

On effectue ensuite un décapage ionique (en milieu neutre) de la surface (plasma etching en langue anglaise) qui a pour but non pas un enlèvement de matière notable de la surface mais un criblage de cette dernière à une échelle microscopique de l'ordre de quelques dizaines de nanomètres. Le résultat de ce décapage ionique est de creuser le substrat d'une profondeur de 50 nm au plus et n'affecte que de façon négligeable la rugosité de 0,25 à 0,85 μm obtenue après traitement par HF ; on obtient par contre, à l'échelle de 10 nm une microrugosité telle que montrée schématiquement sur la figure 3 où des creux ou microfissures de 10 à 50 nm de diamètre environ sont représentés par des points 5. La gamme de reliefs imbriqués que forment les vallées 3, les criques 4 et les creux 5, avec des échelles qui varient d'un ordre de grandeur entre un relief et le relief supérieur, confère à la surface du substrat une aptitude à l'adhérence par cohésion mécanique remarquable, et constitue le moyen général de l'invention. Le décapage ionique (ou microgravure) peut être effectué de la façon suivante : le substrat est transféré dans l'enceinte d'un dispositif de pulvérisation cathodique, de préférence tel que décrit ci-dessous en référence à la figure 4. La pression dans l'enceinte est d'abord baissée jusqu'à obtention d'un vide secondaire de $2 \times 10^{-7}$ Torr. De l'argon (Ar) est ensuite admis dans l'enceinte jusqu'à une pression de 80 mTorr et, dans la suite des opérations, on s'efforce de maintenir cette pression de 80 mTorr à ± 10 % près. Le substrat étant placé sur la cathode du dispositif, on règle le potentiel entre les électrodes de façon à obtenir une puissance par unité de surface comprise entre 50 W/cm$^2$ et 71 W/cm$^2$ pendant une durée comprise entre 160 et 200 s. Sans précautions particulières, comme la cathode est en cuivre et que la partie de la cathode qui n'est pas recouverte par le substrat est aussi bombardée par les ions Ar, des ions cuivre sont arrachés à la cathode et certains de ces ions se redéposent sur la surface du substrat, ce qui est nuisible au dépôt ultérieur d'une première couche métallique d'adhérence dans la mesure où cette dernière n'est de préférence pas en cuivre. Afin d'éviter cette pollution de la surface du substrat par du cuivre, on peut interposer entre la surface de la cathode et le revers du substrat un écran mince en silice ou, de préférence, un film, d'une épaisseur de 0,5 à 1 $\mu$m, dans le même métal que celui qui sera utilisé ultérieurement comme première couche métallique d'adhérence.

Les étapes suivantes du procédé selon l'invention consistent en l'application sur la surface du substrat d'une ou de plusieurs couches métalliques par un procédé de pulvérisation cathodique, de préférence dans un même dispositif, comme représenté à la figure 4, sans variation notable de la pression partielle de 80 mTorr, immédiatement à la suite de l'étape de décapage ionique (ou microgravure) de la surface du substrat décrite au paragraphe précédent.

Le dispositif 6 de la figure 4 comporte une enceinte 7 à travers laquelle pénètrent une buse 8 et une buse 9. La buse 8 sert à la création d'un vide secondaire de $2 \times 10^{-7}$ Torr et la buse 9 à l'admission d'argon sous une pression de 80 mTorr. Le substrat 11 avec sa surface à métalliser 12 est placé sur une électrode 13 reliée à un point de connexion électrique extérieur 14. De préférence, un film mince en silice ou en métal de sous couche 15 est interposé entre l'électrode 13 et le substrat 11. Une électrode multiple 16 de polarité opposée est placée en regard de l'électrode 13. L'électrode 16 comporte plusieurs plateaux tels que 17, 18, qui peuvent, par rotation de l'ensemble, être placés successivement à la façon d'un barrillet chacun exactement en face de l'électrode 13, à quelques centimètres. Chaque plateau d'électrode 16 est relié respectivement à un point de connexion extérieur, tel que 19 pour le plateau 17 et 21 pour le plateau 18.

Pendant l'étape de décapage ionique, le plateau de l'électrode 13 soumise à un potentiel négatif est une cathode et le plateau métallique de l'électrode 16 situé en face est une anode, ce dernier étant soumis à un potentiel positif.

Pour l'étape qui consiste en l'application sur la surface 12 d'une première couche métallique d'adhérence, partant de l'étape de décapage ionique précédente, un plateau de l'électrode 16 est placé en face de l'électrode 13. Ce plateau est de préférence en Cr, NiCr, Ti ou W et plus généralement en un métal qui présente autant que possible une certaine compatibilité chimique avec la silice. Les polarités entre électrodes sont inversées de façon que l'électrode 13 devienne l'anode. L'opération est menée pendant une durée comprise entre 59 et 73 s, avec une puissance par unité de surface comprise entre 79 et 95 W/cm$^2$ de façon telle qu'il se dépose sur la surface 12 une sous couche métallique de 15 à 30 nm d'épaisseur, à partir du métal arraché au plateau de l'électrode 16, soit une épaisseur très faible comparable à l'épaisseur de silice arrachée lors de l'étape précédente de décapage ionique. On notera que si l'on utilisait, à ce stade du procédé, à la place du dépôt métallique par pulvérisation cathodique le dépôt chimique par trempage dans des bains contenant des sels métalliques, l'épaisseur de la sous couche, plus difficile à contrôler dans cette dernière éventualité, conduirait à des épaisseurs de sous couche nettement plus élevées, de l'ordre de 100 à 150 nm. En variante, dans le but d'accélérer les particules métalliques en direction de la surface 12, on peut utiliser pour cette étape le procédé de pulvérisation cathodique magnétron. L'application de NiCr, avec dépôt métallique ultérieur permet la réalisation de résistances sur le substrat 11. On notera que la pulvérisation cathodique permet un choix assez large pour le métal dont est constituée la sous couche.

En vue de la réalisation de couches métalliques conductrices on peut ensuite procéder à l'application d'une deuxième couche métallique conductrice par pulvérisation cathodique. Cette deuxième couche est plus épaisse que la première dite encore sous couche ; elle est de l'ordre de plusieurs centaines de nm d'épaisseur et typiquement entre 300 et 400 nm d'épaisseur, ce qui revient à combler les criques 4 et les vallées 3 de la figure 2b. Pour l'application de cette deuxième couche métallique, l'électrode 16 est tournée, après application de la première couche métallique, de façon qu'un plateau convenable pour l'application de la deuxième couche métallique soit présenté en face de l'anode 13 et que la connexion reliée à ce plateau soit portée à un potentiel négatif adéquat, ce dernier plateau étant de préférence en Au, Ag ou Cu. Pour obtenir l'épaisseur requise, on applique entre les électrodes actives une différence de potentiel apte à procurer une puissance par unité de surface comprise entre 118 W/cm$^2$ et 142 W/cm$^2$ pendant une durée de l'ordre de 5 à 7 mn. Pour des fréquences élevées, supérieures à 10 GHz, les épaisseurs faibles, inférieures à 0,5 $\mu$m pour la deuxième couche métallique peuvent être obtenues par pulvérisation cathodique.

En variante, on peut éventuellement appliquer de façon connue, toujours par pulvérisation cathodique entre les première et deuxième couches métalliques, une couche barrière ou couche de diffusion, de préférence en Ni.

A ce stade du procédé on obtient un substrat de silice (respectivement de quartz, de saphir) qui est métallisé sur toute une face, la métallisation comportant au moins une première couche ou sous couche et une deuxième couche ou couche conductrice. En règle générale, on réalise de la même manière la métallisation de la deuxième face. Les métallisations des tranches ou bords sont également réalisées sauf si l'on envisage des caches métalliques ou autres adaptés. Le choix est fait en fonction de la présence ou de l'absence de liaisons interfaciales. A ce sujet, par l'expression "métallisation d'une surface de substrat", on entend dans tout le texte la métallisation d'une face, des deux faces ou des deux faces et des bords du substrat. Pour la réalisation de configurations métalliques, le substrat est extrait de l'enceinte 7 du dispositif 6 et des procédés photolithographiques classiques permettent d'effectuer les configurations souhaitées. On notera à ce sujet que la faible rugosité de la surface, de l'ordre de Ra = 0,5 $\mu$m, tout en convenant aux fréquences élevées pour une minimisation des pertes par courants de Foucault, facilite la gravure chimique visant à éliminer le métal sur les parties de surface du substrat qui doivent rester isolantes et qui constituent le complément des parties occupées par les configurations.

Lorsque les circuits électroniques à réaliser sur le substrat sont prévus pour des fréquences de fonctionnement assez faibles pour que l'effet de peau ne se manifeste pas, et que toute l'épaisseur des couches métalliques contribue à la conduction électrique, une épaisseur de couche de plusieurs microns peut être nécessaire. Une plus grande épaisseur de l'ordre de plusieurs dizaines de microns peut aussi être requise pour le dépôt de pistes métalliques sur de la silice, ces pistes étant destinées à des essais de pelage ultérieurs. Ces grandes épaisseurs peuvent être obtenues par renforcement par voie électrolytique ce qui constitue le dépôt éventuel d'une troisième couche métallique conductrice. De préférence le dépôt par voie électrolytique s'effectue sur des configurations métalliques adhérant au substrat plutôt que sur la surface de substrat entièrement métallisée.

Certaines configurations métalliques de circuits hybrides couches minces ou de circuits hyperfréquences comportent à la fois des résistances et des conducteurs sur le même substrat en silice. Dans ce cas le substrat à métalliser conformément au procédé selon l'invention est extrait de l'enceinte du dispositif de pulvérisation cathodique après l'application de la première couche métallique d'adhérence qui, en l'occurrence, est constituée de NiCr. Ensuite, des configurations métalliques pour les résistances et pour les conducteurs sont créées par photolithographie sur la surface ; parmi ces configurations, celles destinées aux résistances sont recouvertes de résine résistant à la ou aux étapes ultérieures de dépôt métallique par pulvérisation cathodique ; après quoi le dépôt de métal conducteur par pulvérisation cathodique avec renforcement électrolytique éventuel peut s'effectuer comme décrit ci-dessus.

Le procédé selon l'invention est applicable à la réalisation de configurations métalliques conductrices de surface sur des circuits intégrés lorsque ces derniers comportent une couche de passivation externe constituée par de la silice.

Les forces de pelage qu'il est possible d'atteindre par la mise en oeuvre de l'invention, ces forces étant mesurées au moyen de tests précis par arrachement de bandes métalliques de 0,5 mm, 1 mm et 2 mm de large déposées sur de la silice, du quartz ou du saphir comme décrit ci-dessus, atteignent des valeurs élevées, supérieures à 80 cN/mm, et typiquement égales à 120 cN/mm.

## Revendications

1. Procédé permettant de faire adhérer du métal sur une surface de substrat en silice, quartz, verre, ou en saphir, selon lequel la surface à métalliser est d'abord rendue rugueuse par abrasion mécanique en vue d'obtenir une rugosité superficielle comprise entre 0,2 $\mu$m et 0,7 $\mu$m puis soumise à un traitement chimique de décapage par immersion pendant une durée efficace dans une solution aqueuse d'acide fluorhydrique, caractérisé en ce qu'il comporte en outre les étapes ultérieures suivantes :
   - le décapage ionique de la surface jusqu'à une profondeur inférieure à 50 nm,
   - l'application sur la surface d'une première couche métallique d'adhérence par pulvérisation cathodique.

2. Procédé permettant de faire adhérer du métal sur une surface de substrat selon la revendication 1, caractérisé en ce que le décapage ionique de la surface est effectué par un plasma d'argon avec une puissance par unité de surface comprise entre 50 W/cm$^2$ et 71 W/cm$^2$ pendant une durée comprise entre 160 s et 200 s.

3. Procédé permettant de faire adhérer du métal sur une surface de substrat selon la revendication 1 ou 2, caractérisé en ce que pendant l'étape de décapage ionique de la surface un film mince en matériau de la première couche métallique d'adhérence est interposé entre ledit substrat et l'électrode qui sert de support au substrat.

4. Procédé permettant de faire adhérer du métal sur une surface de substrat selon l'une des revendications 1 à 3, caractérisé en ce qu'il comporte en outre l'étape ultérieure consistant en l'application sur la surface métallisée d'une deuxième couche métallique conductrice, par pulvérisation cathodique, dont l'épaisseur est inférieure à 0,5 μm.

5. Procédé permettant de faire adhérer du métal sur une surface de substrat selon l'une des revendications 1 à 4 pour réaliser des circuits hybrides couches minces ou des circuits hyperfréquences, consistant dans un premier temps à métalliser sur toute une face les substrats, puis à créer sur ces substrates métallisés, des configurations métalliques.

6. Procédé permettant de faire adhérer du métal sur une surface de substrat selon la revendication 4 ou 5, caractérisé en ce qu'il comporte en outre l'étape ultérieure consistant en l'application sur la surface métallisée d'une troisième couche métallique conductrice de renforcement par dépôt électrolytique.

7. Substrat en silice, quartz, verre, ou en saphir, obtenu par la mise en oeuvre du procédé selon la revendication 5 ou 6, comportant une première couche métallique d'adhérence en Cr, NiCr, Ti ou W, et une deuxième et troisième couches métalliques conductrices en Au, Ag ou Cu.

## Claims

1. A method of adhering a metal to surface of a substrate of silica, quartz, glass or sapphire, whereby the surface to be metallized is first roughened by mechanical abrasion in order to obtain a surface roughness lying between 0.2 μm and 0.7 μm and is then subjected to a chemical etching treatment by immersion in an aqueous solution of hydrofluoric acid, characterized in that it further comprises the following subsequent steps:
   - ion etching (in a neutral medium) of the surface down to a depth smaller than 50 nm,
   - applying to the surface a first metal adhesion layer by cathode sputtering.

2. A method of adhering metal to a substrate surface as claimed in Claim 1, characterized in that the ion etching of the surface is effected by an argon plasma with a power per unit area of between 50 W/cm² and 71 W/cm² for a duration of between 160 s and 200 s.

3. A method of adhering metal to a substrate surface as claimed in Claim 1 or 2, characterized in that a thin film of the material of the first metal adhesion layer is interposed between the said substrate and the electrode serving as a support for the substrate during the step of ion etching of the surface.

4. A method of adhering metal to a substrate surface as claimed in any one of Claims 1 to 3, characterized in that it moreover comprises the subsequent step of applying to the metallized surface a second conductive metal layer, whose thickness is less than 0.5 μm by cathode sputtering.

5. A method of adhering metal to a substrate surface as claimed in any one of the Claims 1 to 4 for the realization of thin-film hybrid circuits or v.h.f. circuits, consisting in that first one entire surface of the substrates is metallized, after which metal configurations are created on these metallized substrates.

6. A method of adhering metal to a substrate surface as claimed in Claim 4 or 5, characterized in that it moreover comprises the subsequent step of applying to the metallized surface a third conductive metal reinforcement layer by electrolytic deposition.

7. A substrate of silica, quartz, glass or sapphire obtained by a method as claimed in Claim 5 or 6, comprising a first metal adhesion layer of Cr, NiCr, Ti or W and a second and a third conductive metal layer of Au, Ag or Cu.

## Patentansprüche

1. Verfahren, das es ermöglicht, daß Metall an einer Oberfläche eines Substrats aus Silizium, Quarz, Glas oder Saphir haftet, wobei die zu metallisierende Oberfläche zunächst durch mechanischen Abrieb aufgerauht wird, damit eine Oberflächenrauhigkeit zwischen 0,2 μm und 0,7 μm erhalten wird, und danach einer chemischen Ätzbehandlung ausgesetzt wird, indem sie während einer geeigneten Zeit in eine wässrige Lösung von Fluorwasserstoffsäure getaucht wird, dadurch gekennzeichnet, daß das Verfahren weiterhin die nachfolgenden Verfahrensschritte aufweist:
   - das Ionenätzen der Oberfläche bis zu einer Tiefe von weniger als 50 nm,
   - das Niederschlagen einer ersten metallischen Haftschicht durch Kathodenzerstäubung.

2. Verfahren, das es ermöglicht, daß Metall an einer Oberfläche eines Substrats haftet nach Anspruch 1, dadurch gekennzeichnet, daß das Ionenätzen der Oberfläche durch ein Argonplasma erfolgt mit einer Leistung je Oberflächeneinheit zwischen 50 W/cm$^2$ und 71 W/cm$^2$ und während einer Zeitperiode zwischen 160 s und 200 s.

3. Verfahren, das es ermöglicht, daß Metall an einer Oberfläche eines Substrats haftet nach Anspruch 1 oder 2, dadurch gekennzeichnet, daß beim Ionenätzen der Oberfläche zwischen dem genannten Substrat und der als Substratträger wirksamen Elektrode eine dünner Film aus dem Material der ersten metallischen Haftschicht vorgesehen wird.

4. Verfahren, das es ermöglicht, daß Metall an einer Oberfläche eines Substrats haftet nach einem der Ansprüche 1 bis 3, dadurch gekennzeichnet, daß das Verfahren außerdem den folgenden Verfahrensschritt aufweist, der daraus besteht, daß auf der metallisierten Oberfläche im Kathodenzerstäubungsverfahren eine zweite leitende metallische Schicht angebracht wird, deren Dicke weniger als 0,5 μm beträgt.

5. Verfahren, das es ermöglicht, daß Metall an einer Oberfläche eines Substrats haftet nach einem der Ansprüche 1 bis 4 zum Verwirklichen von Dünnschichthybridschaltungen oder -höchstfrequenzschaltungen und das daraus besteht, daß zunächst eine ganze Fläche des Substrats metallisiert wird, und daß danach auf diesen metallisierten Substraten metallische Konfigurationen erzeugt werden.

6. Verfahren, das es ermöglicht, daß Metall an einer Oberfläche eines Substrats haftet nach Anspruch 4 oder 5, dadurch gekennzeichnet, daß das Verfahren außerdem den letzten Verfahrensschritt aufweist, und zwar das Anbringen einer dritten leitenden metallischen Verstärkungsschicht durch elektrolytischen Niederschlag.

7. Silizium-, Quarz-, Glas- oder Saphirsubstrat, erhalten durch Durchführung des Verfahrens nach Anspruch 5 oder 6, mit einer ersten metallischen Haftschicht aus Cr, NiCr, Ti oder W, und mit einer zweiten und dritten metallischen leitenden Schicht aus Au, Ag oder Cu.

10 μ

FIG.1a

10 μ

3

3

FIG.2a

1 μ

1

2

FIG.1b

1 μ

4

3

FIG.2b

10 μ

5

FIG.3

7    19    21    6

16

17    18

12    11

15

13

14    9    8

FIG.4